# FASCICULE DE BREVET EUROPEEN

(11) **EP 0 326 465 B1**
(45) Date de publication et mention de la délivrance du brevet: **31.03.1993**
(21) Numéro de dépôt: 89400169.2
(22) Date de dépôt: 20.01.1989
(51) Int. Cl.: H01L 27/10, G11C 17/00, H01L 29/78

(54) **Mémoire EEPROM à grille flottante avec transistor de sélection de ligne de source**
Schwebender Gate-EEPROM-Speicher mit einem Transistor zu Sourceleitungsauswahl
Floating-gate EEPROM memory with a transistor for source line selection

(30) Priorité: 26.01.1988 FR 8800859
(43) Date de publication de la demande: 02.08.1989
(73) Titulaire: SGS-THOMSON MICROELECTRONICS S.A., 94250 Gentilly (FR)
(72) Inventeur: Bergemont, Albert, F-75116 Paris (FR)
(74) Mandataire: Ballot, Paul Denis Jacques

(56) Documents cités:
- FR-A- 2 468 972
- US-A- 4 087 795
- PATENT ABSTRACTS OF JAPAN, vol. 6, no. 95 (E-110)[973], 3 juin 1982, page 165 E 110; & JP-A-57 30 373
- SIEMENS FORSCHUNGS- UND ENTWICKLUNGSBERICHTE RESEARCH AND DEVELOPMENT REPORTS, vol. 4, no. 6, 1975, pages 345-351, Springer Verlag; B. RÖSSLER et al.: "Erasable and electrically reprogrammable read-only memory using the N-channel SIMOS one-transistor cell"

## Description

L'invention concerne les mémoires en circuit-intégré, et plus précisément les mémoires de type EEPROM, c'est-à-dire des mémoires non volatiles, programmables et effaçables électriquement.

L'article de G. Samachisa et autres dans la revue IEEE Journal of Solid-State Circuits vol.SC-22 N°5, Octobre 1987, intitulé "A 128K Flash EEPROM Using Double-Polysilicon Technology", décrit une mémoire EEPROM dont les points-mémoire comportent un transistor à grille flottante. La programmation des points s'effectue par effet dit de "porteurs chauds", c'est-à-dire qu'on applique une différence de potentiel entre la source et le drain du transistor et une différence de potentiel entre la grille de commande et la source; la circulation d'un courant entre source et drain en présence d'un champ électrique important entre le substrat et la grille flottante provoque l'injection d'électrons dans la grille flottante, mettant ainsi le point-mémoire dans un état dit "programmé". L'effacement du point-mémoire s'effectue par effet tunnel en appliquant une différence de potentiel entre grille de commande et drain, créant un champ électrique élevé dans un sens tendant à évacuer des électrons de la grille flottante vers le drain.

L'article cité ci-dessus montre cependant qu'il y a un problème de contrôle de la quantité d'électrons évacuée de la grille flottante lors de l'effacement. L'idéal est d'aboutir après effacement à une grille flottante sans aucune charge. Mais si la tension ou la durée de l'impulsion d'effacement appliquée entre grille et drain sont insuffisantes, l'effacement ne sera que partiel et on risquera de ne pas pouvoir distinguer un point-mémoire programmé d'un point-mémoire effacé. C'est pourquoi, en l'absence de possibilité efficace de contrôler avec certitude la quantité de charges évacuée ou la quantité de charges résiduelle après effacement, on tend plutôt à surdimensionner la tension et la durée de l'impulsion d'effacement de manière à avoir une certitude que les électrons de la grille flottante ont bien été évacués.

L'article cité ci-dessus montre que cela crée alors une autre difficulté. En effet, si on évacue trop d'électrons, on risque d'aboutir à une charge positive de la grille flottante, c'est-à-dire qu'on évacue une quantité d'électrons plus grande que la quantité d'électrons en excès présente dans une grille programmée. Ce risque est d'autant plus important si on effectue une opération d'effacement sur une grille de transistor non programmé puisque cette grille n'est pas chargée négativement au départ et qu'on lui applique une tension tendant à la décharger. Or, plus on charge positivement la grille flottante plus le courant de fuite sous le transistor, en l'absence de tension de commande sur sa grille de commande, est important. Lorsqu'on va faire une opération de programmation d'un transistor d'une colonne de points-mémoire, la grille de commande de ce transistor sera portée à un potentiel positif par rapport à la source, ainsi que son drain. La grille des autres transistors restera à un potentiel nul de manière que ces transistors ne soient pas conducteurs pendant l'opération de programmation. Mais si certains d'entre eux ont un courant de fuite trop important, dû par exemple à des charges positives sur leur grille flottante, le potentiel de drain du transistor qu'on cherche à programmer va chuter et détériorer l'efficacité d'injection d'électrons dans la grille flottante de sorte qu'on risque d'aboutir à une mauvaise programmation de ce point-mémoire.

Pour éviter cet inconvénient, l'article cité ci-dessus propose de mettre en série avec chaque transistor à grille flottante un transistor contrôlé par la grille de commande du transistor à grille flottante. Ce transistor en série n'est pas un transistor à grille flottante; son courant de fuite peut être maintenu à une valeur basse en dopant convenablement son canal (transistor normalement enrichi); ce transistor empêche donc la circulation du courant de fuite du transistor à grille flottante avec lequel il est en série, même si la grille flottante est chargée positivement par suite d'un effacement trop poussé.

Pour réduire au minimum l'accroissement de surface produit par le transistor supplémentaire introduit dans chaque point-mémoire, l'article précité propose que ce transistor supplémentaire soit tout simplement constitué par une portion de la grille de commande du transistor à grille flottante, recouvrant une partie du canal du transistor non recouverte par la grille flottante. En d'autres mots, la grille de commande est prolongée au delà de la grille flottante au dessus d'une région de canal en série avec le canal du transistor à grille flottante.

Cela nécessite, comme on va le voir, que deux opérations de gravure soient prévues pour définir les dimensions transversales de la grille flottante d'une part et de la grille de commande d'autre part. On montrera ci-après quelles sont les inconvénients de cette double gravure, à propos d'un exemple concret de réalisation de la mémoire.

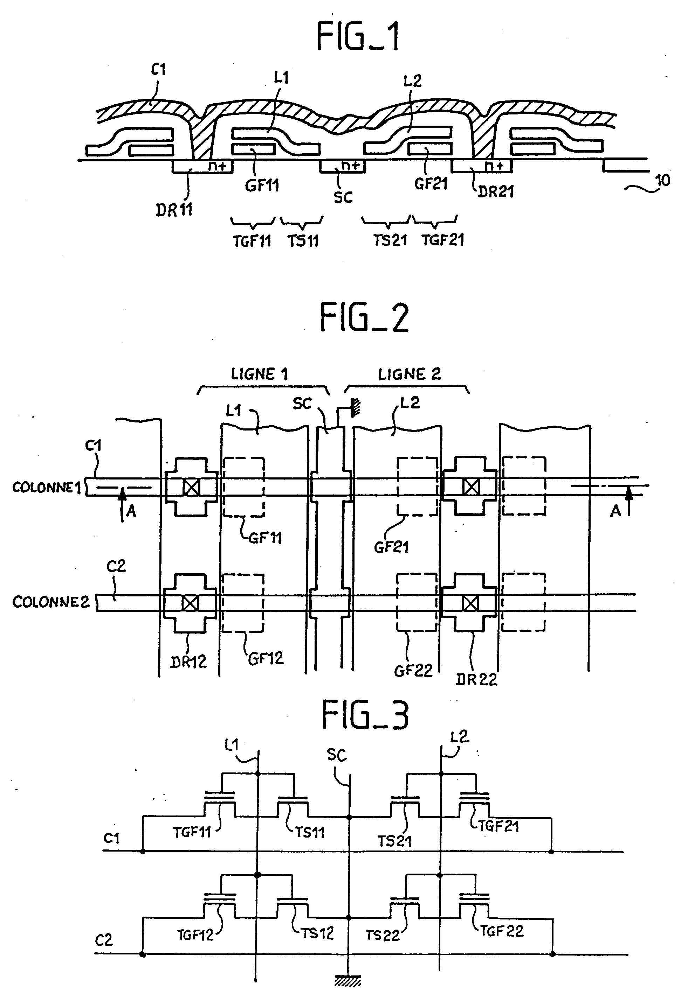

Les figures 1, 2, et 3 montrent une structure de mémoire qu'on peut imaginer à partir du point-mémoire proposé dans l'art antérieur. La figure 1 est une vue en coupe de deux points-mémoires adjacents d'une même colonne (coupe selon la ligne A-A de la figure 2); la figure 2 représente une vue de dessus d'une portion de la mémoire, montrant quatre points-mémoire à l'intersection de deux lignes adjacentes et deux colonnes adjacentes; la figure 3 représente un schéma électrique équivalent de la structure des figures 1 et 2.

La mémoire est réalisée à partir d'un substrat semiconducteur 10 qui est par exemple de type P. Chaque point mémoire comporte un transistor à grille flottante et un transistor de sélection. Les transistors à grille flottante sont désignés respectivement par TGF11 à l'intersection de la ligne 1 et de la colonne 1, TGF12 à l'intersection de la ligne 1 et de la colonne 2, TGF21 à l'intersection de la ligne 2 et de la colonne 1, et TGF22 à l'intersection de la ligne 2 et de la colonne 2. Les transistors de sélection sont désignés respectivement par TS11, TS12, TS21, TS22 les indices ayant la même signification que pour les transistors à grille flottante.

Le drain (DR11, DR12, DR21, DR22) de chaque transistor à grille flottante est une région diffusée de type N reliée à un conducteur de colonne, C1 pour la colonne 1, C2 pour la colonne 2.

Les grilles flottantes (GF11, GF12, GF21, GF22) sont des rectangles de silicium polycristallin surplombant une partie de substrat semiconducteur de type P adjacente aux régions de drain. Les grilles de commande des transistors à grille flottante sont constituées par des bandes de silicium polycristallin L1 pour la ligne 1, L2 pour la ligne 2, s'étendant perpendiculairement aux conducteurs de colonne C1, C2. Ces bandes surplombent à la fois les grilles flottantes des transistors de la ligne correspondante, et à ce titre elles constituent bien les grilles de commande des transistors à grille flottante; mais elles s'étendent aussi au dessus d'une partie de substrat de type P non recouverte par la grille flottante et adjacente à la partie recouverte par la grille flottante, et à ce titre elles constituent aussi des grilles de commande des transistors de sélection.

La zone semiconductrice située entre les deux bandes L1 et L2 est une ligne diffusée SC dopée de type N, constituant la source des transistors de sélection rattachés aux deux lignes L1 et L2. Les sources des transistors de sélection sont en effet destinées à être portées à un potentiel qui est le même pour tous les transistors du plan mémoire (même si ce potentiel varie au cours du temps) et il est très fréquent dans les plans mémoires classiques EPROM ou EEPROM de disposer ainsi deux lignes de transistors adjacentes avec une ligne diffusée de type N entre ces lignes de transistors, pour servir de ligne de source à deux rangées de transistor à la fois. Cela évite de prévoir une ligne de source par ligne de transistors et on économise ainsi de la place.

De même que deux transistors adjacents d'une même colonne partagent une source commune, de même chaque transistor partage son drain de l'autre côté avec un autre transistor adjacent de la même colonne.

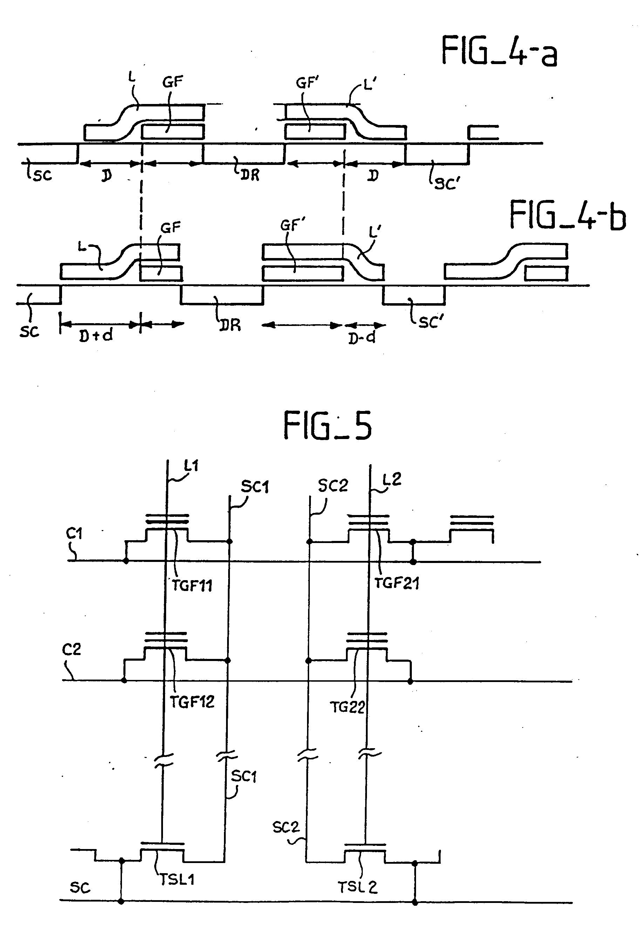

La figure 4 (4a, 4b) est destinée à illustrer le problème que pose la présence de deux grilles superposées de largeurs différentes.

Le procédé de fabrication débute par la formation de régions actives délimitées par de l'oxyde de silicium épais non représentées entourant les régions de drain et les lignes de source et séparant les transistors adjacents de colonnes voisines.

Pour les explications qui suivent, on suppose
1) que les dimensions des grilles d'un même niveau sont obtenues avec une grande précision, mais que leur position peut être défectueuse lorsqu'elles sont réalisées sans autoalignement; cette hypothèse est réaliste;
2) que les bords des grilles du côté adjacent au drain sont gravées en une seule opération (autoalignement de la gravure de 1 grille flottante et de la grille de commande), et que le dopage de drain et de source est réalisé ensuite (autoalignement du drain et de la source avec les grilles); mais que les bords des grilles du côté de la source sont gravés en deux opérations distinctes puisque le bord de la grille flottante du côté de la source doit être gravé avant le dépôt du deuxième niveau de silicium polycristallin; ces deux gravures ne sont pas autoalignées l'une par rapport à l'autre.

A la figure 4a on a supposé que les grilles flottantes et les grilles de commande sont exactement alignées à l'endroit désiré les unes par rapport aux autres : le bord des grilles de commande L et L′ (du côté de la source SC ou SC′ respectivement) est à une distance désirée D du bord de la grille flottante (GF ou GF′ respectivement) du côté de la source également.

Or le bord de la grille flottante GF ou GF′ est défini par une opération de gravure du premier niveau de silicium polycristallin, avant dépôt du deuxième niveau de silicium polycristallin. Ce bord constitue donc une référence pour la gravure du deuxième niveau. Au contraire, l'autre bord de la grille flottante (du côté du drain DR) sera gravé en même temps que le deuxième niveau pour que les bords des deux grilles superposées soient autoalignés du côté du drain DR.

Il peut exister un défaut d'alignement entre les deux gravures successives. A la figure 4b, on a représenté un cas défavorable dans lequel le masque d'alignement des grilles de commande (c'est-à-dire des lignes de mot L et L′) est légèrement décalé vers la gauche par rapport au motif des grilles flottantes GF et GF′ déjà gravées.

Il en résulte, comme on le voit clairement sur la figure 4 que le bord gauche de la ligne de mot L est à une distance D + d (au lieu de D) du bord gauche de la grille flottante GF, et inversement que le bord droit de la ligne de mot L′ est à une distance D - d du bord droit de la grille flottante GF′. Les deux points-mémoire adjacents de la figure 4, qui présentent théoriquement une symétrie de miroir par rapport au drain DR qu'ils partagent, ne sont plus du tout symétriques à la figure 4b. L'un a une longueur de canal trop courte pour le transistor à grille flottante et trop longue pour le transistor de commande; l'autre a au contraire une longueur de canal trop longue pour le transistor à grille flottante et une longueur de canal trop courte pour le transistor de commande.

Il en résulte une très grande imprécision sur les dimensions de la grille flottante et sur la longueur de canal du transistor de sélection et du transistor à grille flottante. En particulier, pour tenir compte du cas de la figure 4b, il faut prévoir une dimension théorique de la grille flottante égale à la dimension minimale acceptable pour la grille flottante (par exemple 1 micron) additionnée de l'erreur d'alignement (par exemple 0,7 micron). Si la grille de commande était exactement positionnée par rapport à la grille flottante, on pourrait prévoir une dimension de grille flottante de 1 micron ou 1,2 micron par exemple. A cause de la double gravure, on doit passer à 2 microns environ pour être sûr que le point-mémoire fonctionne même en cas de défaut d'alignement.

De plus, même en augmentant la taille nominale de la grille flottante, on n'empêchera pas qu'il y ait une dispersion de caractéristiques, avec des transistors à grille flottante large et des transistors adjacents avec des grilles flottantes étroites, ce qui nuit à l'uniformité de programmation des points-mémoire.

Une mémoire non volatile électriquement effaçable et reprogrammable organisée en un réseau de points-mémoire correspondant à la partie précaractérisante de la revendication 1 est connue du document Patent Abstracts of Japan, vol. 6, no. 95 (E-110)[973], 3 juin 1982, page 165, (JP-A 57 30373).

Pour réduire l'encombrement des cellules de mémoire et la dispersion entre les géométries des cellules de la mémoire, tout en réalisant les objectifs désirés de suppression des courants de fuite pouvant provenir notamment d'une charge positive de la grille flottante après une opération d'effacement, on propose selon l'invention que chaque point-mémoire soit constitué par un transistor à grille flottante, la grille flottante s'étendant de la région de drain jusqu'à la région de source (par conséquent sans transistor de sélection constitué par un prolongement de la grille de commande au dessus d'une région de substrat non recouverte par la grille flottante), un transistor de sélection unique pour toute une ligne de transistors étant prévu entre une ligne de source correspondant à cette ligne de transistors et un conducteur de commande de toutes les sources de transistors à grille flottante du plan mémoire, ce transistor de sélection ayant une grille de commande reliée aux grilles de commande des transistors à grille flottante de la même ligne.

En d'autres mots, la structure proposée par l'invention pour une mémoire non volatile effaçable et reprogrammable électriquement est la suivante: la mémoire est organisée en lignes et colonnes de points-mémoire, chaque point-mémoire comportant un transistor à grille flottante ayant une source, un drain, une grille flottante, et une grille de commande; les drains des transistors d'une même colonne sont reliés à une même ligne de bit et les grilles de commande des transistors d'une même ligne sont reliées à une même ligne de mot; les sources des transistors d'une même ligne sont reliées au drain d'un transistor de sélection commun à toute la ligne, ce transistor ayant sa grille reliée à la ligne de mot des transistors de la ligne considérée et sa source reliée à un conducteur commun à toutes les lignes de transistors. Ce conducteur commun sera généralement relié à la masse.

De préférence, les sources des transistors reliés à une même ligne de mot sont constituées par une ligne semiconductrice diffusée dans le substrat, cette ligne diffusée constituant aussi une région de drain pour le transistor de sélection. De préférence aussi, si les grilles de commande des transistors à grille flottante d'une ligne sont constituées par une bande conductrice constituant une ligne de mot, alors on prévoit que cette bande constitue aussi la grille de commande du transistor de sélection. Le transistor de sélection est placé en principe en bout de ligne. On peut aussi en prévoir un à chaque bout de la ligne.

Dans une réalisation particulière, on pourra prévoir que les lignes de source diffusées sont plus dopées que les drains des transistors à grille flottante.

D'autres caractéristiques et avantages de l'invention apparaîtront à la lecture de la description détaillée qui suit et qui est faite en référence aux dessins annexés dans lesquels:
- les figures 1 à 3, déjà décrites, représentent une structure de mémoire regroupant des techniques connues dans l'art antérieur;
- la figure 4 représente l'influence sur la largeur de grille flottante de défauts d'alignements lors de la gravure du premier puis du deuxième niveau de silicium polycristallin;
- la figure 5 représente un schéma électrique montrant la différence de principe entre la présente invention et la structure des figures 1 à 3;
- la figure 6 représente une coupe verticale de la structure selon la ligne B-B de la figure 7, pour un mode de réalisation de l'invention;
- la figure 7 représente une vue de dessus analogue à la figure 2, montrant une constitution possible du plan mémoire selon l'invention.

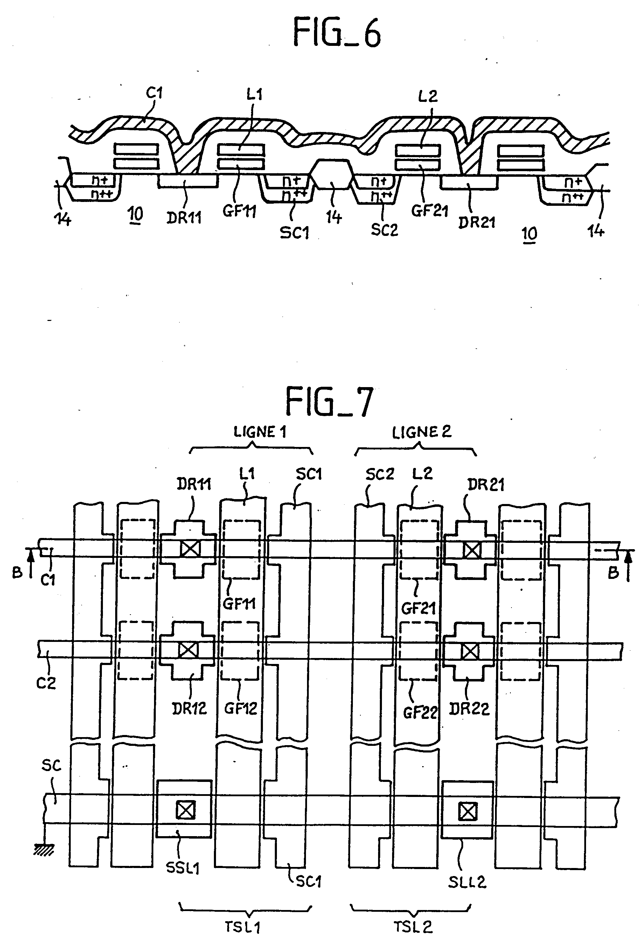

Sur la figure 5, on peut voir le principe de l'invention; chaque ligne de transistors possède sa ligne de source, SC1 pour la ligne 1 et SC2 pour la ligne 2; les lignes de source des différentes lignes de transistors ne sont pas reliées entre elles et ne sont pas directement portées au potentiel de la masse comme c'est le cas dans l'art antérieur. Au contraire, une ligne de source est reliée au drain d'un transistor de sélection respectif correspondant à cette ligne de source; la grille de ce transistor est reliée aux grilles de commande des transistors à grille flottante de la même ligne, et la source de ce transistor de sélection est reliée à un conducteur SC qui amène le potentiel nécessaire aux sources des transistors à grille flottante en phase de programmation (en principe le potentiel du conducteur SC est celui de la masse).

Le transistor de sélection de ligne de source est désigné par TSL1 pour la ligne 1 et TSL2 pour la ligne 2. Seule la ligne de source correspondant à une ligne de points-mémoire désignée sera effectivement portée au potentiel de la masse; la désignation de la ligne de points se fait en effet par application sur la ligne de mot (L1 ou L2) d'un potentiel tendant à rendre conducteurs les transistors à grille flottante, et le montage est tel que ce potentiel rend également conducteur le transistor de sélection de ligne de source. Les autres transistors de sélection de ligne de source restent bloqués et empêchent l'évacuation vers la source des courants de fuite des transistors des lignes non sélectionnées.

Les figures 6 et 7 représentent, respectivement en coupe (selon la ligne B-B de la figure 7) et en vue de dessus, une disposition pratique possible pour l'invention.

Les lignes de source SC1 et SC2 sont des lignes semiconductrices diffusées de type N+ (pour des transistors à canal N), s'étendant parallèlement aux lignes de mot L1 et L2; elles sont délimitées d'une part par des régions d'oxyde de silicium épais 14 qui les séparent de la source de la ligne adjacente, et d'autre part par les bords des grilles des transistors à grille flottante. grilles des transistors à grille flottante.

Les drains (DR11 à DR22) sont constitués comme dans l'art antérieur par des rectangles diffusés de type N+ délimités d'une part par l'oxyde épais et d'autre part par les grilles des transistors à grille flottante.

Les grilles flottantes (GF11, GF21) sont des rectangles de silicium polycristallin (premier niveau de silicium polycristallin) isolés du substrat semiconducteur et surplombant l'espace entre une région de drain d'un transistor et la ligne de source correspondante.

Les lignes de mot (L1, L2) sont des bandes de silicium polycristallin (deuxième niveau de silicium polycristallin) qui constituent directement les grilles de commande des transistors à grille flottante; les lignes de mot sont séparées des grilles flottantes par de l'oxyde de silicium mince; la largeur des bandes constituant les lignes de mot est exactement la même que la largeur des grilles flottantes et cette largeur est de préférence définie par une seule opération de gravure (la longueur ayant été définie par une gravure précédente du premier niveau de silicium puisque les grilles flottantes ne s'étendent pas en bandes mais sont localisées à chaque site de transistor).

Les régions de source et de drain sont toutes définies par implantation et diffusion, après gravure des deux grilles, de sorte que non seulement les grilles ont leurs bords autoalignés entre eux, mais les régions de source et de drain sont également autoalignées par rapport à ces grilles (et par rapport aux zones d'oxyde épais).

Les lignes de bit C1, C2 sont de préférence des conducteurs métalliques (par exemple en aluminium) s'étendant en bandes transversalement aux lignes de mot et venant contacter ponctuellement, à travers une couche isolante qui les sépare du silicium polycristallin et du substrat semiconducteur, les régions de drain des transistors correspondant à cette ligne de mot.

Les lignes de source SC1, SC2 seront plus dopées que les régions de drain (dopage par double implantation Phosphore + Arsenic) de manière à supporter la tension d'effacement (de 16 à 20 V) sans claquage de diode.

Il n'y a pas de grille flottante au dessous de la ligne de mot à l'endroit du transistor de sélection : la ligne de mot n'est séparée du substrat que par une mince couche d'oxyde de sorte qu'elle peut servir à commander la conduction du transistor de sélection.

Le transistor de sélection est un transistor normalement enrichi, c'est-à-dire non conducteur en présence d'une tension grille-source nulle.

La largeur de canal des transistors de sélection est suffisamment importante pour ne pas introduire de chute de tension excessive pendant la programmation notamment.

Enfin ce transistor de sélection est formé en même temps que les transistors à grille flottante et sa source et son drain sont autoalignés par rapport à la ligne de mot L1 et sont délimités par ailleurs par de l'oxyde épais qui les sépare des autres régions de source et drain de la structure.

De préférence, comme cela est représenté sur la figure 7, chaque transistor partage son drain avec un transistor adjacent de la même colonne, et cela est vrai pour les transistors à grille flottante comme pour les transistors de sélection.

## Revendications

1. Mémoire non volatile électriquement effaçable et reprogrammable, organisée en un réseau de lignes et colonnes de points-mémoire, chaque point-mémoire comportant un transistor à grille flottante (TGF11) ayant une source (SC1), un drain (DR1), une grille flottante (GF11), et une grille de commande, les drains des transistors d'une même colonne étant reliés à une même ligne de bit (C1) et les grilles de commande des transistors d'une même ligne étant reliées à une même ligne de mot (L1), caractérisée en ce que les sources des transistors à grille flottantes d'une même ligne étant reliées au drain d'un transistor de sélection de ligne de source (TSL1), commun à toute la ligne, caractérisé en ce que ledit transistor de sélection a sa source (SSL1) reliée à un conducteur (SC) commun à toutes les lignes de transistors de sélection et a sa grille reliée à la ligne de mot des transistors de la ligne considérée.

2. Mémoire selon la revendication 1, caractérisée en ce que les sources des transistors à grille flottante d'une même ligne sont constituées par une ligne semiconductrice diffusée constituant aussi le drain du transistor de sélection.

3. Mémoire selon la revendication 2, caractérisée en ce que les grilles de commande des transistor à grille flottante d'une même ligne sont constituées par une bande conductrice et en ce que la grille du transistor de sélection correspondant à cette ligne est constituée par un prolongement de la même bande.

4. Mémoire selon l'une des revendications 1 à 3, caractérisée en ce que les sources des transistors à grille flottante sont plus dopées que leur drain.

## Patentansprüche

1. Nichtflüchtiger, elektrisch löschbarer und umprogrammierbarer Speicher, der in einem Gitter aus Zeilen und Spalten von Speicherpunkten organisiert ist, wobei jeder Speicherpunkt einen Transistor mit schwebendem Gate-Anschluß (TGF11) enthält, der eine Source-Zone (SC1), eine Drain-Zone (DR1), ein schwebendes Gates (GF11) und ein Steuer-Gate aufweist, wobei die Drain-Zonen der Transistoren einer gleichen Spalte an eine gleiche Bitleitung (C1) angeschlossen sind und die Steuer-Gates der Transistoren einer gleichen Zeile an eine gleiche Wortleitung (L1) angeschlossen sind, und wobei die Source-Zonen der Transistoren mit schwebendem Gate einer gleichen Zeile an die Drain-Zone eines Sourceteilungs-Wähltransistors (TSL1) angeschlossen sind, der der ganzen Zeile gemeinsam angehört, dadurch gekennzeichnet, daß der Wähltransistor mit seiner Source-Zone (SSL1) an einen allen Wähltransistorzeilen gemeinsam angehörenden Leiter (SC) angeschlossen ist und sein Gate an die Wortleitung der Transistoren der betrachteten Zeile angeschlossen ist.

2. Speicher nach Anspruch 1, dadurch gekennzeichnet, daß die Source-Zonen der Transistoren mit schwebendem Gate einer gleichen Zeile von einer diffundierten halbleitenden Zeile gebildet sind, die auch die Drain-Zone des Wähltransistors bildet.

3. Speicher nach Anspruch 2, dadurch gekennzeichnet, daß die Steuer-Gates der Transistoren mit schwebendem Gate einer gleichen Zeile von einem leitenden Streifen gebildet sind und daß das Gate des dieser Zeile entsprechenden Wähltransistors von einer Verlängerung dieses Streifens gebildet ist.

4. Speicher nach einem der Ansprüche 1 bis 3, dadurch gekennzeichnet, daß die Source-Zonen der Transistoren mit schwebendem Gate stärker dotiert sind als ihre Drain-Zonen.

## Claims

1. A non-volatile, electrically erasable and reprogrammable memory which is arranged as an array of lines and columns of memory locations, each memory location including a floating gate transistor (TGF11) having a source (SC1), a drain (DR1), a floating gate (GF11), and a control gate, the drains of the transistors of a common column being connected to a common bit line (C1) and the control gates of the transistors of a common line being connected to a common word line (L1), the sources of the floating gate transistors of a common line being connected to the drain of a source line selection transistor (TSL1) common to the whole line, characterized in that said selection transistor has its source (SSL1) connected to a conductor (SC) common to all the lines of selection transistors and has its gate connected to the word line of the transistors of the respective line.

2. A memory according to claim 1, characterized in that the sources of the floating gate transistors of a common line are formed of a diffused semiconductive line also forming the drain of the selection transistor.

3. A memory according to claim 2, characterized in that the control gates of the floating gate transistors of a common line are formed of a conductive band and in that the gate of the selection transistor corresponding to that line is formed of a continuation of the same band.

4. A memory according to any one of claims 1 to 3, characterized in that the sources of the floating gate transistors are more heavily doped than their drains.
